# EUROPEAN PATENT SPECIFICATION

(11) **EP 4 386 437 B1**
(45) Date of publication and mention of the grant of the patent: **14.05.2025**
(21) Application number: 23307132.3
(22) Date of filing: 05.12.2023
(51) Int. Cl.: G01S 7/481, G01S 7/484, G01S 17/10, H01S 5/042, H01S 5/40

(54) **DRIVER CIRCUIT, CORRESPONDING LASER-DRIVING DEVICE, LASER LIGHTING MODULE, LIDAR APPARATUS AND METHODS OF OPERATION**
TREIBERSCHALTUNG, ENTSPRECHENDE LASERANSTEUERUNGSVORRICHTUNG, LASERBELEUCHTUNGSMODUL, LIDAR-VORRICHTUNG UND BETRIEBSVERFAHREN
CIRCUIT D'ATTAQUE, DISPOSITIF D'ATTAQUE LASER, MODULE D'ÉCLAIRAGE LASER, APPAREIL LIDAR ET PROCÉDÉS DE FONCTIONNEMENT CORRESPONDANTS

(30) Priority: 14.12.2022 IT 202200025605
(43) Date of publication of application: 19.06.2024
(73) Proprietor: STMicroelectronics (Rousset) SAS, 13790 Rousset (FR); STMicroelectronics S.r.l., 20864 Agrate Brianza (MB) (IT)
(72) Inventor: LETOR, Romeo, 95030 Mascalucia (IT); RUSSO, Alfio, 95024 Acireale (IT); LECCI, Nadia, 95030 Tremestieri Etneo (IT); PIZZARDI, Antonio Filippo Massimo, 95045 Misterbianco (IT); PAVLIN, Antoine, 13540 Puyricard (FR); POLETTO, Vanni, 20151 Milano (IT); BRERA, Marco, 20145 Milano (IT); BIANCHI, Simone, 15122 Alessandria (IT)
(74) Representative: Buzzi, Notaro & Antonielli d'Oulx S.p.A.

(56) References cited:
- WO-A1-2019/167039
- US-A1- 2022 013 982
- US-A1- 2022 149 588

## Description

### Technical field

The present disclosure relates to a laser-driving device for LIDAR (Light Detection And Ranging or Laser Imaging Detection And Ranging) applications. In particular, it relates to a laser-driving device (e.g., implemented as a System-in-Package, SiP) including a driver circuit couplable to a plurality of laser diodes and a control circuit, to a lighting module including the laser-driving device and the laser diodes, to a LIDAR apparatus including the lighting module, and to methods of operating the laser-driving device and the laser lighting module.

### Technological background

Thanks to their 3D sensing capacity and to the ability to function in the dark and in unfavorable meteorological conditions, LIDAR systems are increasingly used in the automotive sector, in possible combination with video cameras and radar systems, for environmental mapping and for other safety applications, such as emergency braking, detection of pedestrians and collision avoidance.

Very short high-current pulses (such as current pulses that have an intensity in the range of tens of amps with rise and fall times in the (sub)nanosecond time range, for example, of the order of 100 ps) are desirable for laser diodes for LIDAR systems used for measuring the distances with time-of-flight (ToF) measurements techniques with medium-to-short distance values (e.g., distances of less than approximately 100 m with resolution of measurement of about ±15 cm).

Arrays of laser diodes including laser diodes activated in sequence or in parallel are also used for improving the signal-to-noise (S/N) ratio of the return signal received. Multi-channel drivers offer the possibility of selecting the diode (diodes) to be activated with a short current pulse of high intensity.

Circuits, devices, lighting modules and apparatuses for use in LIDAR applications are known, for instance, from references US 2022/0013982 A1 and US 2022/0014187 A1, which are assigned to the same Applicants of the instant application. Additionally, references US 2022/0013984 A1 and US 2021/0218223 A1, which are also assigned to the same Applicants of the instant application, disclose implementation details of such circuits and devices.

In particular, document US 2022/0013982 A1 discloses a laser lighting module comprised in a LIDAR apparatus. The laser lighting module is formed by a laser-driving module and a plurality of laser diodes. The laser diodes are activated selectively (in a pulsed way) by respective half-bridges. Each half-bridge comprises: a respective first switch coupled between a first node or line (common to all the half-bridges) and a respective second driving node; and a respective second switch coupled between the respective second driving node and a reference line or node (e.g., ground) common to all the half-bridges. The cathodes of the laser diodes are coupled to the reference node, and the anodes of the laser diodes are coupled to the second driving nodes of the respective half-bridges. Consequently, the laser diodes are arranged in a common-cathode configuration. The half-bridges are driven by respective driving circuits coupled to the control terminals (the gates) of the switches of the half-bridges. Coupled between the first line and the reference node a resonant tank is present comprising an inductor and a capacitor connected in series. The inductor is arranged in an intermediate position between the first line and an intermediate node of the resonant tank circuit, and the capacitor is arranged in an intermediate position between the intermediate node and the reference node. The intermediate node is coupled to a charge circuit (also referred to in what follows as regulator) which receives a supply voltage. A control switch, such as a GaN (gallium-nitride) field-effect transistor (for example, a GaN HEMT), is coupled in an intermediate position between the first line and the reference node.

Document WO 2019/167039 A1 is also of interest, insofar as it discloses a current driver integrated-circuit for high-resolution LIDAR, which uses a regulated constant current source followed by a network of power switches that cooperatively act as a current routing network. The driver comprises a regulated current source that sources a current to a supply node. A laser diode is coupled to the supply node. The network of switches includes a first power switch between the supply node and ground, a second power switch between the supply node and ground, and a third power switch in series to the laser diode. Operation of the driver is divided into an idle state and two phases. In the idle state, the first switch is on, providing a closed path for the current flow of the source, while the second and third switches are off. At this point, the system is ready for outputting a current pulse. In the turn on phase, the third switch is on and the first switch turns off. Consequently, the current from the source is routed towards the laser diode. The turn off phase is commenced by simultaneously turning the second switch on and the third switch off, thereby causing the inductor current to rapidly route back off the load through the second switch.

Document US 2022/0149588 A1 is also of interest.

However, existing LIDAR systems present non-negligible parasitic inductances (e.g., higher than 1 nH) and/or capacitances, in particular on account of the use of the arrays of laser diodes, which cause degraded electrical performance of the latter. For instance, known solutions may be limited by a current rating in the range of about 20 A, mainly due to the maximum current capability of the laser-selecting switches and the maximum power dissipation of the switch that is used to drive a resonant current wave. Attaining a higher current rating by increasing the chip size would result in: lengthier connections to ground (which result in increased stray inductances in the commutation loop), increased output capacitance of the switch that drives the resonant current wave, deteriorated switching time and increased current overshoot due to resonance in the commutation loop with a period in the nanosecond range (which result in a poor current control in the nanosecond range) .

Reduction of the parasitic inductances and/or capacitances is therefore a desirable feature in the implementation of a driver circuit for laser diodes designed for high current ratings.

### Object and summary

An object of one or more embodiments is to contribute in providing laser-driving devices having an improved topology and/or chip layout that results in reduced parasitic inductances and/or capacitances.

The invention is defined by a laser-driving device in accordance with claim 1, and by a method of operating a laser-driving device in accordance with claim 12. Further preferred embodiments are defined in the dependent claims.

One or more embodiments may relate to a corresponding laser lighting module including a laser-driving device, one or more laser diodes and a power supply arrangement.

One or more embodiments may relate to a corresponding LIDAR apparatus including a laser lighting module.

One or more embodiments may relate to corresponding methods of operating the laser-driving device and the laser lighting module.

The claims are an integral part of the technical teaching provided herein in respect of the embodiments.

According to a first aspect of the present description, a laser-driving device (e.g., in the form of a System-in-Package, SiP) includes a driver circuit couplable to a plurality of laser diodes. The driver circuit includes a semiconductor body having a first surface. The driver circuit includes a first control switch (e.g., transistor) having a drain terminal electrically coupled to a drain metallization and having a source terminal electrically coupled to a first source metallization. The drain metallization is configured to be electrically coupled to a power supply line and the first source metallization is configured to be coupled to cathode terminals of the laser diodes and to a reference node. The driver circuit includes a second control switch (e.g., transistor) having a drain terminal electrically coupled to the drain metallization and having a source terminal electrically coupled to a second source metallization. The second source metallization is configured to be coupled to the cathode terminals of the laser diodes and to a reference node. The driver circuit includes a plurality of high-side switches (e.g., transistors), each high-side switch having a respective drain terminal electrically coupled to the drain metallization and having a respective source terminal electrically coupled to a respective third source metallization. Each third source metallization is coupled to a respective drive output node for driving an anode terminal of a respective laser diode of the plurality of laser diodes. The drain metallization, the first source metallization, the second source metallization and the third source metallizations face the first surface of the semiconductor body, which is also configured to face the laser diodes. The second source metallization and the third source metallizations are aligned with one another in a direction of alignment and are superimposed, orthogonally to the direction of alignment, to the respective source terminals of the second control switch and of the high-side switches. The laser-driving device further includes a control circuit for driving the first control switch, the second control switch and the high-side switches to cyclically generate pulses for activating the laser diodes. The control circuit is configured to:
- sense a voltage across a capacitor of an external resonant circuit;
- in response to the sensed voltage reaching a first threshold value, close the first control switch and the second control switch, thereby enabling the resonant circuit to oscillate with a current (e.g., increasing current) that flows in an inductor of the resonant circuit and is split between the first control switch and the second control switch;
- in response to the current flowing in the inductor of the resonant circuit reaching a second threshold value, open the first control switch and keep closed the second control switch for a first time interval, whereby the current flows entirely through the second control switch;
- in response to expiration of the first time interval, open the second control switch and close a first selected high-side switch for a second time interval, whereby the current flows entirely through the first selected high-side switch and is output via a respective first drive output node; and
- in response to expiration of the second time interval, open the first selected high-side switch.

One or more embodiments may thus provide a laser-driving device for laser diodes having improved topology and layout that reduce parasitic inductances.

According to another aspect of the present description, a laser lighting module includes a laser-driving device according to one or more embodiments and a resonant circuit including an inductor and a capacitor having an intermediate node between them. The resonant circuit is coupled between the power supply line and the reference node. The laser lighting module further includes a charging circuitry coupled between a supply node and the intermediate node of the resonant circuit for charging the capacitor of the resonant circuit, and a plurality of laser diodes. Each of the laser diodes has an anode terminal electrically coupled to a respective one of the drive output nodes and a cathode terminal electrically coupled to the reference node.

According to another aspect of the present description, a LIDAR apparatus includes a laser light emitter path including a LIDAR mirror module and a laser lighting module according to one or more embodiments, a laser light receiver path including a photodiode module and a receiver circuit coupled to the photodiode module, and a controller circuit. The controller circuit is configured to emit driving signals for the LIDAR mirror module and the laser lighting module, and receive raw data from the receiver circuit coupled to the photodiode module.

According to another aspect of the present description, a method of operating a laser-driving device according to one or more embodiments includes:
- sensing a voltage across a capacitor of an external resonant circuit;
- in response to the sensed voltage reaching a first threshold value, closing the first control switch and the second control switch, thereby enabling the resonant circuit to oscillate with a current that flows in an inductor of the resonant circuit and is split between the first control switch and the second control switch;
- in response to the current flowing in the inductor of the resonant circuit reaching a second threshold value, opening the first control switch and keeping closed the second control switch for a first time interval, whereby the current flows entirely through the second control switch;
- in response to expiration of the first time interval, opening the second control switch and closing a first selected high-side switch for a second time interval, whereby the current flows entirely through the first selected high-side switch and is output via a respective first drive output node; and
- in response to expiration of the second time interval, opening the first selected high-side switch.

According to another aspect of the present description, a method of operating a laser lighting module according to one or more embodiments includes:
- initially opening the first control switch and the second control switch to charge the capacitor via the charging circuitry, and
- operating the laser-driving device according to the method of one or more embodiments.

### Brief description of the drawings

One or more embodiments will now be described, by way of example only, with reference to the annexed figures, wherein:
- Figure 1 is a circuit diagram exemplary of a laser lighting module that may be included in a LIDAR apparatus according to one or more embodiments of the present description;
- Figures 2, 3 and 4 are waveforms exemplary of the resonant current flowing through a resonant circuit according to one or more embodiments of the present description;
- Figure 5 is a circuit diagram exemplary of certain components of a laser lighting module according to one or more embodiments of the present description;

- Figures 6 and 7 are circuit layout diagrams exemplary of the chip layout of a driver circuit according to one or more embodiments of the present description;
- Figure 8 is a time diagram exemplary of the switching behavior of a laser lighting module according to one or more embodiments of the present description; and
- Figure 9 is a circuit block diagram exemplary of a LIDAR apparatus, possibly mounted on a vehicle, according to one or more embodiments of the present description.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment**.**

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

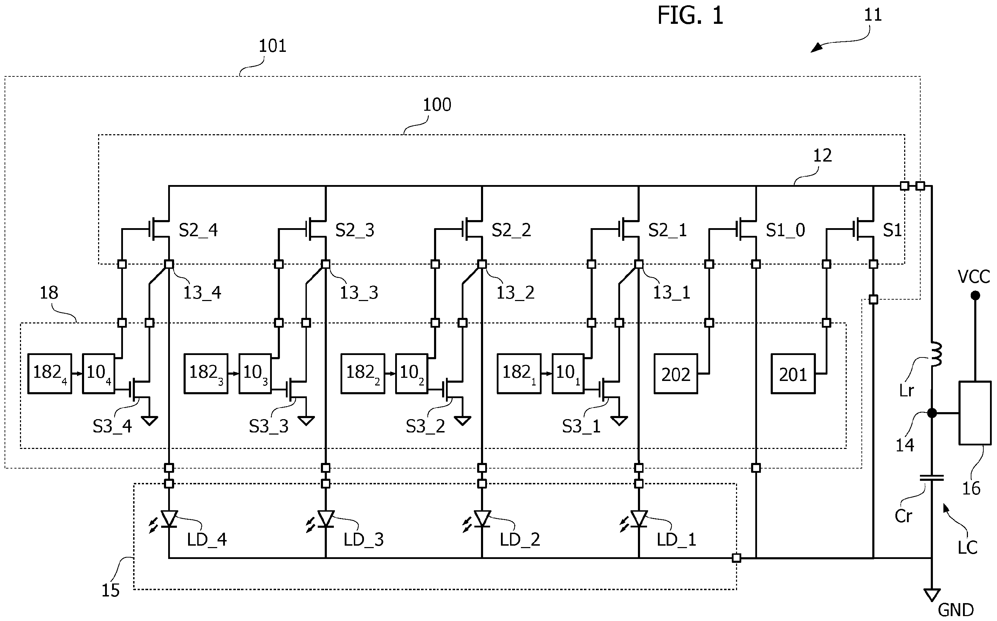

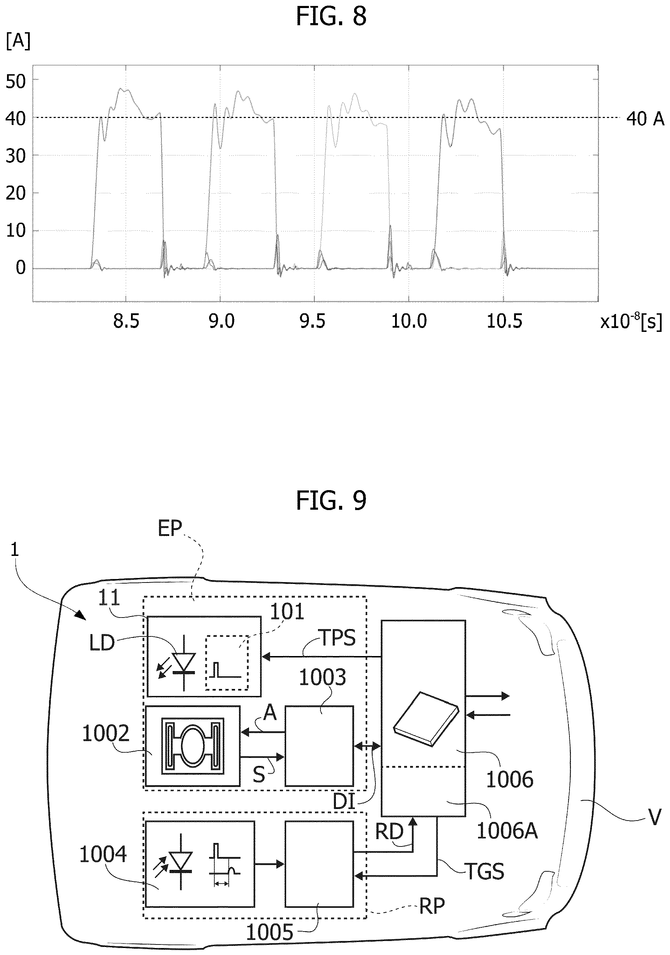

Figure 1 is a circuit diagram exemplary of a laser lighting module 11 that may be included in a LIDAR apparatus 1 (exemplified in Figure 9), according to an embodiment of the present disclosure.

The laser lighting module 11 includes a laser-driving device and a plurality of laser diodes. For instance, in Figure 1 four laser diodes are illustrated, which are arranged in an array and are designated by the reference symbols LD_1, LD_2, LD_3, LD_4 (generally LD_j, where j = 1, 2, ..., n and n is the number of laser diodes that form the array; by way of non-limiting example, thus, n = 4). The laser diodes LD_j are configured to be selectively activated (e.g., in a pulsed way) by respective half-bridge circuits. In particular, each half-bridge circuit includes a pair of electronic switches such as field-effect transistors and, for example, HEMT (High Electron Mobility Transistor) devices and/or MOSFET (Metal-Oxide-Semiconductor Field-Effect Transistor) devices. In detail, each half-bridge circuit includes a high-side switch S2_j (e.g., S2_1, S2_2, S2_3, S2_4 in the example of Figure 1) coupled between a power supply line 12 common to all the half-bridge circuits and a respective driving node 13_j (e.g., 13_1, 13_2, 13_3, 13_4 in the example of Figure 1), and a low-side switch S3_j (e.g., S3_1, S3_2, S3_3, S3_4 in the example of Figure 1) coupled between the respective driving node 13_j and a reference line (e.g., a ground GND, referred to in what follows as reference node GND) common to all the half-bridge circuits. The cathode terminal of each laser diode LD_j is coupled to the reference node GND, and the anode terminal of each laser diode LD_j is coupled to the driving node 13_j of the respective half-bridge circuit (e.g., the laser diodes LD_j are arranged in a common-cathode configuration). Thus, a first half-bridge S2_1, S3_1 drives a first laser diode LD_1, a second half-bridge S2_2, S3_2 drives a second laser diode LD_2, a third half-bridge S2_3, S3_3 drives a third laser diode LD_3, and a fourth half-bridge S2_4, S3_4 drives a fourth laser diode LD_4. The half-bridge circuits are driven by respective driving circuits 10ⱼ coupled to the control terminals (e.g., gate terminals) of the high-side switches S2_j and low-side switches S3_j.

A resonant tank (or circuit) LC that includes an inductor Lr and a capacitor Cr connected in series is coupled between the power supply line 12 and the reference node GND. The inductor Lr is arranged between the power supply line 12 and an intermediate node 14 of the resonant circuit LC, and the capacitor Cr is arranged between the intermediate node 14 and the reference node GND. The intermediate node 14 is coupled to a charge circuit (also referred to in what follows as regulator) 16, of a known type, which receives a supply voltage VCC.

A first control switch S1, such as a gallium nitride (GaN) field-effect transistor (for example, a GaN HEMT), is coupled between the power supply line 12 and the reference node GND. A second control switch S1_0, such as a gallium nitride (GaN) field-effect transistor (for example, a GaN HEMT), is also coupled between the power supply line 12 and the reference node GND. The control switches S1, S1_0 and the half-bridge switches S2_j, S3_j are driven as a function of enable signals supplied, as discussed hereinafter, by a control circuit designated as a whole by reference numeral 18, which includes the half-bridge driving circuits 10ⱼ. It may be considered that the control circuit 18 includes: the half-bridge driving circuits 10ⱼ; respective control circuits 182ⱼ for the half-bridge driving circuits 10ⱼ configured to send to the half-bridge driving circuits 10ⱼ respective enable signals *Ton_S2_j* to enable supply of energy to (and therefore emission of light from) the respective laser diodes LD_j; a control circuit 201 configured to control the first control switch S1 (e.g., driving its control terminal, i.e., a gate terminal in the case of a field-effect transistor); and a control circuit 202 configured to control the second control switch S1_0 (e.g., driving its control terminal, i.e., a gate terminal in the case of a field-effect transistor).

As mentioned earlier, the control circuits 182ⱼ, 201 and 202, as well as the half-bridge driving circuits 10ⱼ, are represented as distinct entities purely for simplicity of description and understanding. These control and driving circuits may be integrated in a single control unit 18, which may also incorporate the low-side switches S3_j. In fact, it will be understood that the components of a laser lighting module 11 as exemplified in Figure 1 may be arranged as follows:
- the high-side switches S2_j and the control switches S1, S1_0, which may all be implemented as GaN power transistors (e.g., configured to operate in the power range of 100 W), may be (monolithically) integrated in a GaN integrated circuit (IC) 100;
- the low-side switches S3_j and the control and driving circuits 10ⱼ, 182ⱼ, 201 and 202, which may all be implemented in a conventional silicon-based CMOS technology (e.g., configured to operate at low power), may be integrated in a CMOS integrated circuit (IC) 18; the GaN circuit 100 and the CMOS circuit 18 may be incorporated in a same package (e.g., as a System-in-Package, SiP, or as a single solid body of semiconductor material) and form an embodiment according to an aspect of the present disclosure (e.g., a laser-driving device 101);
- the laser diodes LD_j may be provided as discrete components or incorporated in an integrated circuit 15, and they may be coupled (e.g., by an end user such as a system integrator) to the laser-driving device 101 (e.g., being mounted on a printed circuit board, PCB, or being housed in a cavity of the solid body of semiconductor material) together with the resonant circuit LC and the regulator 16 to form an embodiment according to another aspect of the present disclosure (e.g., a laser lighting module 11 that may be used as a transmitter stage in a LIDAR apparatus 1 for distance measurement by time-of-flight, ToF, methods).

As described more comprehensively in the following, the control circuit 18 enables co-ordination of operation of the control switches S1 and S1_0 with operation of the high-side switches S2_j and of the low-side switches S3_j in order to generate (ultra)short current pulses (e.g., having rise times and fall times in the order of the (sub)nanosecond time range and, for example, in the order of 100 ps), with high di/dt (e.g., higher than approximately 80 nA/ns) and high magnitude (e.g., reaching 40 A or more), which are switched on the laser diodes LD_j to obtain individual activation (e.g., sequential activation with a delay in the order of 1 ns) and selective emission of light.

In particular, the control switches S1 and S1_0 are connected in parallel to all the light-emission channels, as well as to the resonant circuit LC, and are thus configured to control energy supply from the regulator 16 to the resonant circuit LC, thereby defining the energy content and the peak current of the pulses of the laser diodes LD_j when activated. The regulator 16 can be implemented in a manner known per se so as to charge the capacitor Cr in the resonant circuit LC to a voltage adequate for obtaining a peak current in the resonant circuit LC equal to or higher than a desired pulse current of the laser diodes LD_j.

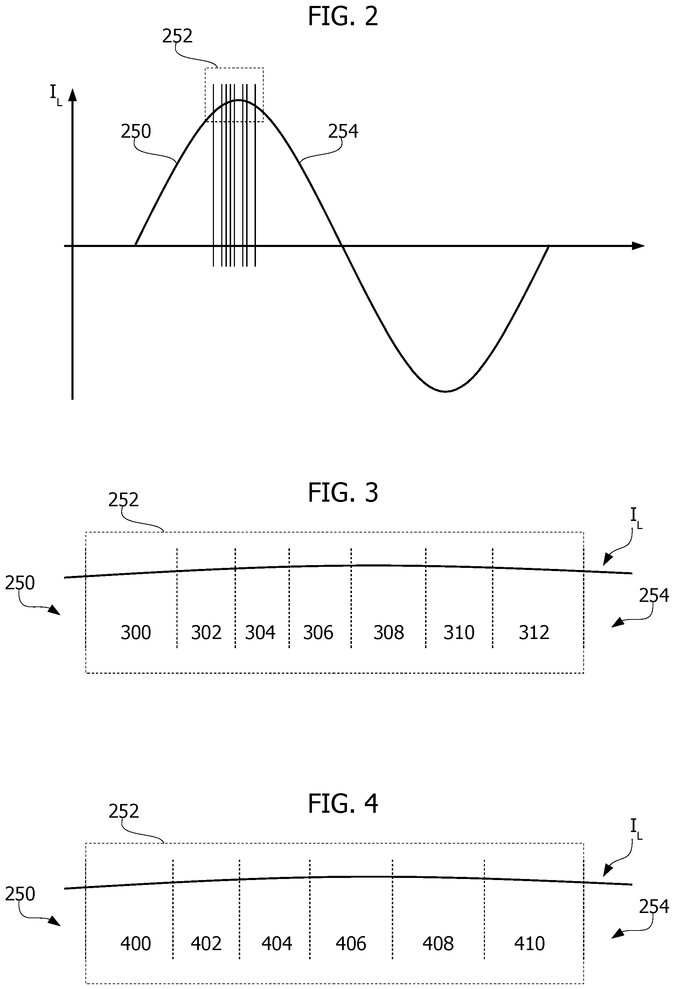

There now follows a description of a method of operating the laser lighting module 11. Such a method may be better understood with reference to Figures 2, 3 and 4, where Figure 2 is a waveform of the resonant current I_{L} flowing through the resonant circuit LC, Figure 3 is an enlarged view of a portion of the waveform of Figure 2 during an independent laser activation phase, and Figure 4 is an enlarged view of a portion of the waveform of Figure 2 during a sequential laser activation phase.

In particular, the high-side and low-side switches S2_j and S3_j are driven by the control circuit 18 in half-bridge configuration so that: when the high-side switch S2_j is on (i.e., closed, conductive), the corresponding low-side switch S3_j is off (open, nonconductive), and the corresponding laser diode LD_j can be activated by injecting current in the latter through the respective light-emission channel; and, when the high-side switch S2_j is off, the low-side switch S3_j is on, thus coupling the respective driving node 13_j to the reference node GND and countering undesired spurious currents that could flow through the laser diode LD_j. It will otherwise be noted that provision of the low-side switches S3_j may not be essential for the operation of the laser lighting module 11, so that one or more embodiments may not be provided with low-side switches S3_j and the corresponding driving circuitry.

In greater detail, the control switches S1 and S1_0 are initially off, so that the capacitor Cr is charged by the regulator 16 to a voltage value (e.g., comprised between approximately 10 V and approximately 20 V) that is adequate for obtaining a desired current in the resonant circuit LC (e.g., comprised between approximately 20 A and approximately 60 A). The control switches S1 and S1_0 are then both switched on, so that the resonant circuit LC starts to oscillate and the current I_{L} increases in the inductor Lr (see, e.g., the waveform portion 250 in Figure 2), with the resonant current being distributed (e.g., shared, split) between switches S1 and S1_0. In response to the fact that the current I_{L} of the resonant circuit LC reaches a threshold, a laser firing phase starts (see, e.g., the waveform portion 252 in Figure 2, which is enlarged in Figures 3 and 4).

If the laser channels are driven in an independent manner (i.e., with the possibility of activating the laser diodes LD_j in any order during the firing phase 252), as exemplified in Figure 3, during an initial portion 300 of the firing phase 252 (e.g., 1 ns before the expected laser firing) the control switch S1 is turned off while the control switch S1_0 remains on, so that the resonant current I_{L} is forced to flow through switch S1_0 only. The control switch S1 will remain off for the entire duration of the firing phase 252. During a subsequent portion 302 of the firing phase 252, the control switch S1_0 is also turned off while one of the high-side switches S2_j is turned on, so that the resonant current I_{L} flowing through the inductor Lr is deviated in the respective laser diode LD_j and light emission takes place for the desired pulse duration (e.g., 1 ns). During a subsequent portion 304 of the firing phase 252, the control switch S1_0 is again turned on while the high-side switch S2_j previously activated is turned off, so that the resonant current I_{L} is again forced to flow through switch S1_0 only. Portions 306 and 310 of the firing phase 252 substantially reproduce the behavior of portion 302 (i.e., switch S1_0 is turned off and one of the high-side switches S2_j is turned on), while portions 308 and 312 of the firing phase 252 substantially reproduce the behavior of portions 300 and 304 (i.e., switch S1_0 is turned on and all the high-side switches S2_j are turned off). At the end of the laser firing phase 252, both control switches S1 and S1_0 are switched on again (see, e.g., the waveform portion 254 in Figure 2).

According to a different driving scheme, if the laser channels are driven in a sequential manner (i.e., activating all the laser diodes LD_j sequentially), as exemplified in Figure 4, during an initial portion 400 of the firing phase 252 (e.g., 1 ns before the expected laser firing) the control switch S1 is turned off while the control switch S1_0 remains on, so that the resonant current I_{L} is forced to flow through switch S1_0 only. The control switch S1 will remain off for the entire duration of the firing phase 252. During a subsequent portion 402 of the firing phase 252, the control switch S1_0 is also turned off while the high-side switch S2_1 is turned on, so that the resonant current I_{L} flowing through the inductor Lr is deviated in the laser diode LD_1 and light emission takes place for the desired pulse duration (e.g., 1 ns). During a subsequent portion 404 of the firing phase 252, the control switch S1_0 remains off, the high-side switch S2_1 is turned off, and the subsequent high-side switch S2_2 is turned on, so that the resonant current I_{L} is deviated in the laser diode LD_2. During a subsequent portion 406 of the firing phase 252, the control switch S1_0 remains off, the high-side switch S2_2 is turned off, and the subsequent high-side switch S2_3 is turned on, so that the resonant current I_{L} is deviated in the laser diode LD_3. During a subsequent portion 408 of the firing phase 252, the control switch S1_0 remains off, the high-side switch S2_3 is turned off, and the subsequent high-side switch S2_4 is turned on, so that the resonant current I_{L} is deviated in the laser diode LD_4. During a subsequent portion 410 of the firing phase 252, the control switch S1_0 is again turned on while the high-side switch S2_4 (as well as the other high-side switches) is turned off, so that the resonant current I_{L} is again forced to flow through switch S1_0 only. At the end of the laser firing phase 252, both control switches S1 and S1_0 are switched on again (see, e.g., the waveform portion 254 in Figure 2).

Therefore, in various embodiments, laser firing is obtained by switching the control switch S1_0 off and on so that when switch S1_0 is off, one of the high-side switches S2_j is on and vice-versa. Switch S1 instead remains off for the entire duration of the laser firing phase. The entirety of the resonant current stored in the resonant circuit LC (Lr, Cr) is transferred to switch S1_0 before the laser firing phase. Switch S1_0 is switched on and off to transfer the current I_{L} in the laser diodes. Switch S1 is switched on again at the end of the laser firing phase.

In various embodiments, the control switches S1 and S1_0 may be dimensioned differently so as to improve the performance of the driver circuit 100, insofar as they play a different function in the operation of the laser lighting module 11. In particular, switch S1 may be larger than switch S1_0. Therefore, switch S1 may have an on-state resistance (R_{Ds,on}) lower than the on-state resistance of switch S1_0, at the price of a higher output capacitance (e.g., switch S1 having an output capacitance being about twice the output capacitance of switch S1_0, such as 180 pF for switch S1 and 90 pF for switch S1_0). By doing so, one or more embodiments facilitate reducing power dissipation, switching time and current overshoot. In fact, the on-state resistance of switch S1 may be dimensioned to minimize the power dissipation while driving the resonant current I_{L} in the inductor Lr (power = R_{DS,ON} * I_{RMS}), insofar as this dimensioning does not affect the switching time of the laser diodes since fast switching is performed by the other control switch S1_0. The power dissipation in switch S1_0 may also be reduced since its short conduction time (e.g., ns range) minimizes the RMS current flowing through switch S1_0. Thus, the switching performance during current transfer to the laser diodes LD_j is improved insofar as the commutation is driven (only) by switch S1_0 that has an output capacitance smaller than switch S1. Such a smaller output capacitance, combined with a reduction of stray inductances obtained by shortening the conduction path of the commutation loop, minimizes the resonant period and the current overshoot during commutation of switch S1_0.

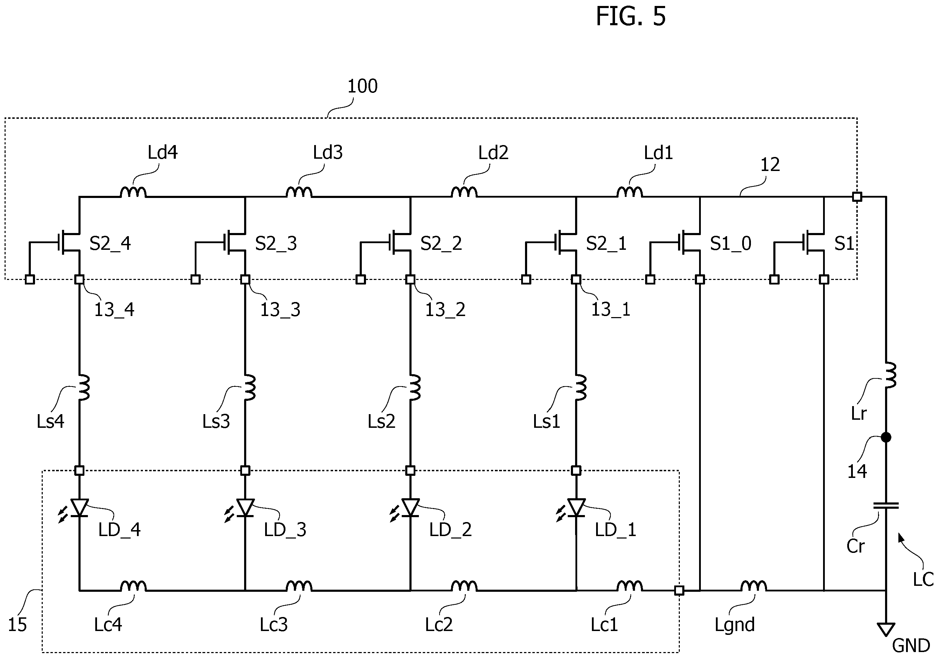

Figure 5 is a circuit diagram that illustrates certain components of the laser lighting module 11. In particular, there are shown the driver circuit 100, the laser diodes LD_j and the resonant circuit coupled to each other, and some parasitic inductances that may be present. For instance, parasitic inductances Ld1, Ld2, Ld3, Ld4 (e.g., having an inductance of about 50 pH each) may be present at the drain terminals of the high-side GaN transistors S2_1, S2_2, S2_3, S2_4, respectively; in particular, inductance Ld1 may be located between the drain terminals of transistors S2_1 and S1_0; inductance Ld2 may be located between the drain terminals of transistors S2_2 and S2_1; inductance Ld3 may be located between the drain terminals of transistors S2_3 and S2_2; and inductance Ld4 may be located between the drain terminals of transistors S2 4 and S2 3. Additionally, parasitic inductances Ls1, Ls2, Ls3, Ls4 (e.g., having an inductance of about 25 pH each) may be present at the source terminals of the high-side GaN transistors S2_1, S2_2, S2_3, S2_4, respectively; in particular, inductance Ls1 may be located between the source terminal of transistor S2_1 and the anode terminal of laser diode LD_1; inductance Ls2 may be located between the source terminal of transistor S2_2 and the anode terminal of laser diode LD**_2;** inductance Ls3 may be located between the source terminal of transistor S2_3 and the anode terminal of laser diode LD_3; inductance Ls4 may be located between the source terminal of transistor S2_4 and the anode terminal of laser diode LD_4. Additionally, parasitic inductances Lc1 (e.g., having an inductance of about 100 pH) and Lc2, Lc3, Lc4 (e.g., having an inductance of about 50 pH each) may be present at the cathode terminals of the laser diodes LD_1, LD_2, LD_3, LD_4, respectively; in particular, inductance Lc1 may be located between the cathode terminal of laser diode S2_1 and the source terminal of GaN transistor S1_0; inductance Lc2 may be located between the cathode terminals of laser diodes LD_2 and LD_1; inductance Lc3 may be located between the cathode terminals of laser diodes LD_3 and LD_2; inductance Lc4 may be located between the cathode terminals of laser diodes LD_4 and LD_3. Additionally, parasitic inductance Lgnd (e.g., having an inductance of about 1 nH) may be located between the source terminals of transistors S1_0 and S1. Additionally, transistor S1_0 may have an output capacitance of about 90 pF and transistor S1 may have an output capacitance of about 180 pF.

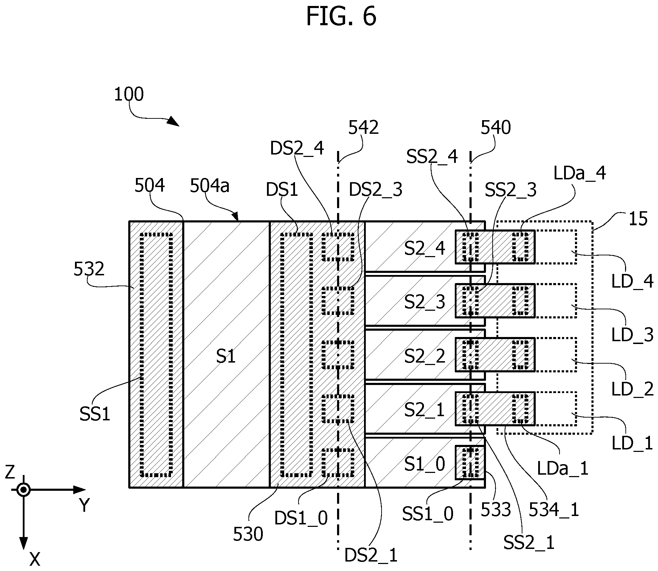

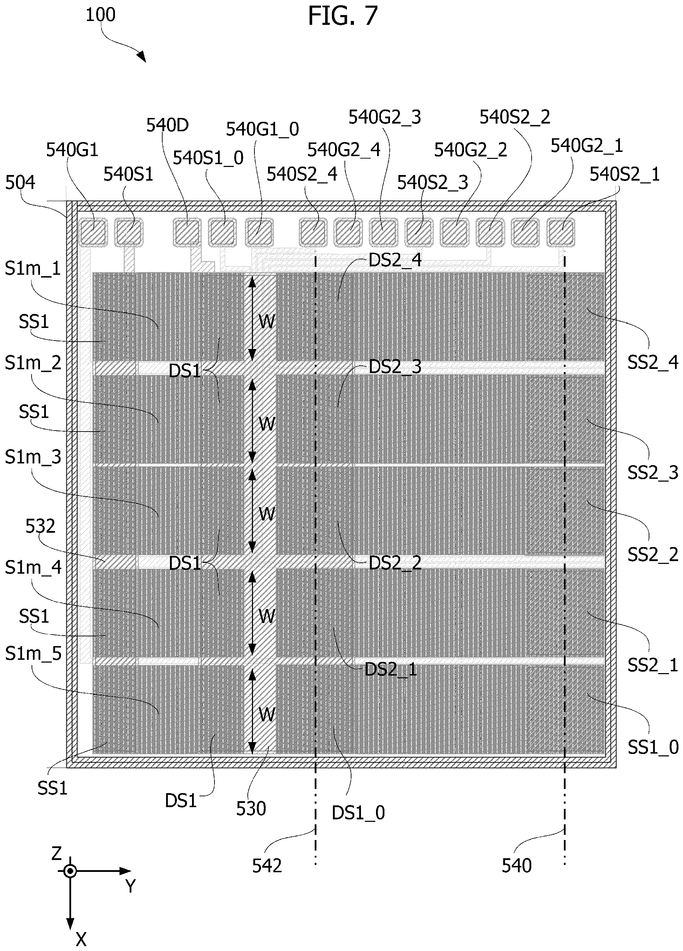

Figures 6 and 7 are layout diagrams that exemplify the chip layout (e.g., in a top view) of a GaN integrated circuit 100 according to one or more embodiments.

The integrated circuit 100 includes a semiconductor body 504 (of semiconductor material such as gallium nitride, GaN). The semiconductor body 504 has a first (e.g., top or upper) surface 504a and a second (e.g., bottom or lower) surface 504b parallel to plane XY and opposite to one another along an axis Z (e.g., axis Z being orthogonal to the plane of the sheet of Figures 6 and 7, which is plane XY). The semiconductor body 504 includes the control switches S1 and S1_0, as well as the high-side switches S2_j (in this example, four switches S2_1, S2_2, S2_3 and S2_4). For the sake of easy of illustration, some parts of the integrated circuit 100 are not shown in Figures 6 and 7 and will not be discussed in the following (e.g., gate terminals and metallizations, possible passivation layers, etc.).

In Figures 6 and 7, the source terminal of the control switch S1 is designated by reference SS1, the source terminal of the control switch S1_0 is designated by reference SS1_0, and the source terminals of the high-side switches S2_j are designated by references SS2_j. Similarly, the drain terminal of the control switch S1 is designated by reference DS1, the drain terminal of the control switch S1_0 is designated by reference DS1_0, and the drain terminals of the high-side switches S2_j are designated by references DS2_j.

The source terminal SS1 of the control switch S1 is electrically connected via conductive vias that extend along direction Z and a source metallization 532 (e.g., including metal such as copper and/or gold) to a reference conductive layer (hereinafter referred to as layer GND, and for example including metal such as copper and/or gold), which extends in the semiconductor body 504. Furthermore, a drain metallization 530 (e.g., a redistribution layer including metal such as copper and/or gold) extends on the drains DS1, DS1_0 and DS2_j of the control switches S1, S1_0 and of the high-side switches S2_j, electrically contacting together these drains DS1, DS1_0 and DS2_j and operating as node 12 (common drain). The drain metallization 530 is electrically connected via further conductive vias to a conductive drain layer (e.g., including metal such as copper and/or gold) that extends in the semiconductor body 504, for example underneath the layer GND 506. Also, the source terminal SS1_0 of the control switch S1_0 is electrically connected via conductive vias that extend along direction Z to a respective source metallization 533 (e.g., including metal such as copper and/or gold). Additionally, the source terminals SS2_j of the high-side switches S2_j are electrically connected via conductive vias that extend along direction Z to respective source metallizations 534_j (e.g., including metal such as copper and/or gold).

Therefore, the source metallization 532 extends on the source terminal SS1 of the control switch S1 so as to set, also through conductive vias, the source terminal SS1 in electrical contact with the layer GND 506. Moreover, each source metallization 534_j extends on the source terminal SS2_j of a respective high-side switch S2_j so as to set, also through conductive vias, the respective source terminal SS2_j in electrical contact with a respective output pin/pad of the integrated circuit 100, which can be used for coupling to the anode terminal LDa_j of a respective laser diode LD_j once the laser lighting module 11 is assembled. Moreover, the common drain metallization 530 extends on the drain terminals DS1, DS1_0 and DS2_j of the control switches and of the high-side switches S2_j so as to set, also through conductive vias, all drain terminals in electrical contact with a respective output pin/pad of the integrated circuit 100, which can be used for coupling to the supply line 12 once the laser lighting module 11 is assembled. The source terminal SS1 of the control switch S1 and the source terminal SS1_0 of the control switch S1_0 may not be connected inside the package of the laser-driving device 101 (e.g., a SiP). The device 101 may be provided with dedicated pads for terminals SS1 and SS1_0, and these pads can be electrically connected outside the package of device 101 (e.g., using vias towards the ground layer of a printed circuit board where the cathode terminals of the laser diodes LD_j are soldered as well). Again, it is noted that gate metallizations and gate connections are not visible in Figures 6 and 7 for the sake of ease of illustration.

Optionally, electrical contact with the source, drain and/or gate terminals of the switches in the GaN integrated circuit 100 are obtained by appropriate I/O pads, designated in Figure 7 by the following references: 540G1 indicating the pad for the gate terminal of the control switch S1, 540S1 indicating the pad for the source terminal SS1 of the control switch S1, 540D indicating the pad for the common drain terminal of the control switches and high-side switches, 540S1_0 indicating the pad for the source terminal SS1_0 of the control switch S1_0, 540G1_0 indicating the pad for the gate terminal of the control switch S1_0, 540S2_j indicating the pad for the source terminal SS2_j of a respective high-side switch S2_j, and 540G2_j indicating the pad for the gate terminal of a respective high-side switch S2_j.

Moreover, optionally, the source terminals SS2_j (and optionally also the source terminal SS1) are located in a position corresponding to a lateral surface of the semiconductor body 504, which joins together the first and second surfaces (parallel to plane XY and opposite along direction Z) of the semiconductor body 504, optionally at the top of the lateral surface of the semiconductor body 504. For instance, they face the (top) surface of the semiconductor body 504 at an edge of the latter that extends between the (top) surface and the lateral surface.

As exemplified in Figures 6 and 7, the source terminals SS2_j of the high-side switches S2_j as well as the source terminal SS1_0 of the control switch S1_0 are aligned with one another in a direction of alignment 540 parallel to the axis X, and the drains DS2_j of the high-side switches S2_j as well as the drain terminal DS1_0 of the control switch S1_0 are aligned with one another in a direction of alignment 542 parallel to the axis X. In addition, the source terminal SS1 and the drain terminal DS1 of the control switch S1 are aligned with one another in a respective direction perpendicular to the directions of alignment 540 and 542, and therefore parallel to the axis Y. Optionally, the control switch S1 has its respective drain terminal DS1 facing the drain terminals DS2_j and DS1_0 of the high-side switches S2_j and of the control switch S1_0, so as to simplify mutual electrical coupling of the latter by the drain metallization 530. The conductive channels of switches S1, S1_0 and S2_j may thus all extend (e.g., in a plane parallel to the first surface 504a of the semiconductor body 504) in the same direction, which is perpendicular to the direction of alignment 540, with the source terminal SS1 of the first control switch S1 being located at an opposite side of the semiconductor body 504 with respect to the source terminals SS1_0 and SS2_j of the second control switch S1_0 and of the high-side switches S2_j.

Optionally, the high-side switches S2_j have an area of extension, in the plane XY defined by the axes X and Y, that is designed on the basis of the RMS currents and/or the peak current that are to flow in the respective laser diodes LD_j. For instance, the area of extension of each high-side switch S2_j is such that a density of RMS current generated thereby is approximately 20 A/mm² (value measured at approximately 25°C) and, optionally, the respective on-state resistance RDSon is approximately 15 mΩ.

As exemplified in Figure 7, the control switch S1 may be implemented as a set of transistors connected in parallel. In particular, switch S1 may comprise a number of transistors equal to the number of high-side transistors S2_j plus the other control transistor S1_0 (e.g., five transistors in the example considered herein, indicated by references S1m_1, S1m_2, S1m_3, S1m_4, and S1m_5, cumulatively also referred to as S1m_k). The transistors S1m_k, the high-side transistors S2_j and the transistor S1_0 may all have the same channel width W, e.g., equal to 500 µm. The transistors S1m_k may have a channel length of about 858 µm. The high-side transistors S2_j as well as the transistor S1_0 may have the same channel length of about 1857 µm. The semiconductor chip 100 may have a total dimension (in the XY plane) of about 3200 µm measured along the X direction and 3104 µm measured along the Y direction.

As previously discussed, the high-side switches S2_j may be coupled to another integrated circuit 15 that includes the laser diodes LD_j. For instance, the integrated circuit 15 may consist of another semiconductor body, and the first surface 504a of semiconductor body 504 may face the surface of such another second semiconductor body.

Furthermore, according to one or more embodiments the solid body is formed by a printed circuit board (PCB) that includes one or more conductive paths (e.g., including metal such as copper), which extend on a first surface. In this case, the laser diodes LD_j, when coupled to the solid body, extend on the first surface and are in electrical contact with one of the aforesaid conductive paths, which electrically contacts also the conductive vias and operates as reference node GND. Moreover, a further conductive path between said conductive paths electrically contacts the drain metallization 530 and operates as first node or line 12. Also electrically coupled (for example, soldered on the first surface) to the solid body are the control circuit 18, the low-side switches S3_j, the resonant circuit LC and the regulator 16.

Figure 8 is a time diagram exemplary of the switching behavior of a laser lighting module 11 according to one or more embodiments. In particular, in Figure 8 are shown the four waveforms of the individual currents flowing through the four laser diodes LD_j during a laser firing phase (e.g., see again phase 252 of Figure 2), which may be characterized by a rise time of about 380 ps and a current overshoot limited to about 5 A with respect to a target current of about 40 A.

Figure 9 is an example of possible use of the laser lighting module 11 (more in particular, of the laser-driving device 101) in a LIDAR application. In particular, Figure 9 shows a vehicle V (e.g., an automobile) comprising the LIDAR apparatus 1. The LIDAR apparatus 1 defines an emitter path EP and a receiver path RP.

The emitter path EP includes the laser lighting module 11, in turn including the laser diodes (here designated by LD) and the laser-driving device 101 that operates as driving system for the laser diodes LD, as discussed previously. The emitter path EP also includes a LIDAR mirror module 1002 **(e.g.,** a MEMS mirror module), which receives actuation signals A from, and supplies sensing signals S to, a mirror driver **(e.g.,** an ASIC) 1003, for instance with the capacity of lighting a surrounding environment with a vertical laser beam and carrying out in a horizontal direction a scan as desired in order to detect, in a reliable way, a pedestrian within a distance of a few meters.

The receiver path RP includes a photodiode module 1004 sensitive to the reflected signal produced as a result of a reflection of the radiation emitted by the emitter path EP on objects lit up by said radiation, and a receiver circuit 1005 coupled to the photodiode module 1004.

The LIDAR apparatus 1 further includes a controller 1006 (e.g., a multi-core microcontroller architecture, possibly including dedicated FPGA/LIDAR hardware accelerators 1006A) configured to: emit signals for triggering and setting the power of the TPS laser to the laser-driving device 101 for laser lighting; exchange driving information DI with the mirror driver 1003 of the mirror module 1002; and receive raw data RD from, and send information of trigger and gain setting TGS to, the receiver circuit 1005 coupled to the photodiode module 1004.

It may be noted that, except for the laser lighting module 11 and more in particular the laser-driving device 101, the architecture illustrated in Figure 9 is conventional in the art, which renders a more detailed description thereof superfluous. This applies, for example, with reference to the co-ordination of operation of the LIDAR apparatus 1 with operation of the vehicle V (for example, in view of the configuration data received in the controller 1006 and of cloud information of status points as issued by the controller 1006).

Without prejudice to the underlying principles, the details and embodiments may vary, even significantly, with respect to what has been described by way of example only, without departing from the extent of protection.

The extent of protection is determined by the annexed claims.

## Claims

1. A laser-driving device (101), comprising a driver circuit (100) couplable to a plurality of laser diodes (LD_j), the driver circuit (100) comprising:
a semiconductor body (504) having a first surface (504a);
a first control switch (S1) having a drain terminal (DS1) electrically coupled to a drain metallization (530) and having a source terminal (SS1) electrically coupled to a first source metallization (532), wherein the drain metallization (530) is configured to be electrically coupled to a power supply line (12) and the first source metallization (532) is configured to be coupled to cathode terminals of said laser diodes (LD_j) and to a reference node (GND);
a plurality of high-side switches (S2_j), each high-side switch having a respective drain terminal (DS2_j) electrically coupled to said drain metallization (530) and having a respective source terminal (SS2_j) electrically coupled to a respective third source metallization (534_j), wherein each third source metallization (534_j) is coupled to a respective drive output node (13_j) for driving an anode terminal (LDa_j) of a respective laser diode (LD_j) of the plurality of laser diodes;
**characterized in that**:
the driver circuit (100) further comprises a second control switch (S1_0) having a drain terminal (DS1_0) electrically coupled to said drain metallization (530) and having a source terminal (SS1_0) electrically coupled to a second source metallization (533), wherein the second source metallization (533) is configured to be coupled to said cathode terminals of said laser diodes (LD_j) and to said reference node (GND);
wherein the drain metallization (530), the first source metallization (532), the second source metallization (533) and the third source metallizations (534_j) face the first surface (504a) of the semiconductor body (504), which is also configured to face the laser diodes (LD_j); and
wherein the second source metallization (533) and the third source metallizations (534_j) are aligned with one another in a direction of alignment (540) and are superimposed, orthogonally to the direction of alignment (540), to the respective source terminals of the second control switch (S1_0) and of the high-side switches (S2_j);
the laser-driving device (101) further comprising a control circuit (18) for driving the first control switch (S1), the second control switch (S1_0) and the high-side switches (S2_j) to cyclically generate pulses for activating said laser diodes (LD_j), the control circuit (18) being configured to:
sense a voltage across a capacitor (Cr) of an external resonant circuit (LC) couplable between the power supply line (12) and the reference node (GND);
in response to said sensed voltage reaching a first threshold value, close the first control switch (S1) and the second control switch (S1_0), thereby enabling the resonant circuit (LC) to oscillate with a current (I_{L}) that flows in an inductor (Lr) of the resonant circuit (LC) and is split between the first control switch (S1) and the second control switch (S1_0);
in response to said current (I_{L}) flowing in the inductor (Lr) of the resonant circuit (LC) reaching a second threshold value, open the first control switch (S1) and keep closed the second control switch (S1_0) for a first time interval (300; 400), whereby said current (I_{L}) flows entirely through said second control switch (S1_0);
in response to expiration of said first time interval (300; 400), open the second control switch (S1_0) and close a first selected high-side switch (S2_1) for a second time interval (302; 402), whereby said current (I_{L}) flows entirely through said first selected high-side switch (S2_1) and is output via a respective first drive output node (13_1); and
in response to expiration of said second time interval (302; 402), open said first selected high-side switch (S2_1).

2. The laser-driving device (101) of claim 1, wherein a conductive channel of said first control switch (S1) is larger than a conductive channel of said second control switch (S1_0), whereby an on-state resistance of said first control switch (S1) is smaller than an on-state resistance of said second control switch (S1_0).

3. The laser-driving device (101) of claim 1 or claim 2, wherein:
said first control switch (S1), said second control switch (S1_0) and said high-side switches (S2_j) have respective conductive channels that extend in a direction perpendicular to said direction of alignment (540) and parallel to said first surface (540a); and
said source terminal (SS1) of said first control switch (S1) is located at an opposite side of said semiconductor body (504) with respect to said source terminals (SS1_0, SS2_j) of said second control switch (S1_0) and of said high-side switches (S2_j).

4. The laser-driving device (101) of any of the previous claims, wherein said first control switch (S1) has a conductive channel having a width equal to the sum of the widths (W) of the conductive channels of said second control switch (S1_0) and of said high-side switches (S2_j).

5. The laser-driving device (101) of any of the previous claims, wherein said first control switch (S1) comprises a plurality of first control transistors (S1m_k) electrically connected in parallel, wherein preferably the number of said first control transistors (S1m_k) is equal to the number of said second control switch (S1_0) plus said high-side switches (S2_j).

6. The laser-driving device (101) of claim 5, wherein each of said first control transistors (S1m_k), each of said high-side switches (S2_j) and said second control switch (S1_0) have respective conductive channels having all the same width (W).

7. The laser-driving device (101) of any of the previous claims, wherein said control circuit (18) is further configured to:
in response to expiration of said second time interval (302; 402), close a second selected high-side switch (S2_2) that is adjacent to said first selected high-side switch (S2_1) for a third time interval (404), whereby said current (I_{L}) is switched from said first selected high-side switch (S2_1) to said second selected high-side switch (S2_2) and flows entirely through said second selected high-side switch (S2_2) and is output via a respective second drive output node (13_2); and
in response to expiration of said third time interval (404), open said second selected high-side switch (S2_2).

8. The laser-driving device (101) of any of claims 1 to 6, wherein said control circuit (18) is further configured to:
in response to expiration of said second time interval (302; 402), close said second control switch (S1_0) for a third time interval (304), whereby said current (I_{L}) is switched from said first selected high-side switch (S2_1) to said second control switch (S1_0) and flows entirely through said second control switch (S1_0); and
in response to expiration of said third time interval (304), open said second control switch (S1_0) and close a second selected high-side switch (S2_j) for a fourth time interval (306), whereby said current (I_{L}) flows entirely through said second selected high-side switch (S2_j) and is output via a respective second drive output node (13_j); and
in response to expiration of said fourth time interval (306), open said second selected high-side switch (S2_j).

9. The laser-driving device (101) of any of the previous claims, wherein said control circuit (18) comprises a plurality of low-side switches (S3_j) configured for coupling to respective ones of said high-side switches (S2_j), wherein each low-side switch (S3_j) is configured to be coupled between a respective one of said drive output nodes (13_j) and said reference node (GND), and wherein said control circuit (18) is further configured to close each of said low-side switches (S3_j) when the respective high-side switch (S2_j) is open.

10. A laser lighting module (11), comprising:
a laser-driving device (101) according to any of the previous claims;
a resonant circuit (LC) including an inductor (Lr) and a capacitor (Cr) having an intermediate node (14) between them, the resonant circuit (LC) being coupled between the power supply line (12) and the reference node (GND);
a charging circuitry (16) coupled between a supply node (VCC) and the intermediate node (14) of the resonant circuit (LC) for charging the capacitor (Cr) of the resonant circuit (LC); and
a plurality of laser diodes (15, LD_j), wherein each of said laser diodes (LD_j) has an anode terminal (LDa_j) electrically coupled to a respective one of said drive output nodes (13_j) and a cathode terminal electrically coupled to said reference node (GND).

11. A LIDAR apparatus (1), comprising:
a laser light emitter path (EP) comprising a LIDAR mirror module (1002) and a laser lighting module (11) according to claim 10;
a laser light receiver path (RP) comprising a photodiode module (1004) and a receiver circuit (1005) coupled to the photodiode module (1004); and
a controller circuit (1006) configured to:
emit driving signals (TPS, DI) for said LIDAR mirror module (1002) and said laser lighting module (11); and
receive raw data (RD) from said receiver circuit (1005) coupled to the photodiode module (1004).

12. A method of operating a laser-driving device (101) according to any of claims 1 to 9, the method comprising:
sensing a voltage across a capacitor (Cr) of an external resonant circuit (LC) coupled between the power supply line (12) and the reference node (GND);
in response to said sensed voltage reaching a first threshold value, closing the first control switch (S1) and the second control switch (S1_0), thereby enabling the resonant circuit (LC) to oscillate with a current (I_{L}) that flows in an inductor (Lr) of the resonant circuit (LC) and is split between the first control switch (S1) and the second control switch (S1_0);
in response to said current (I_{L}) flowing in the inductor (Lr) of the resonant circuit (LC) reaching a second threshold value, opening the first control switch (S1) and keeping closed the second control switch (S1_0) for a first time interval (300; 400), whereby said current (I_{L}) flows entirely through said second control switch (S1_0);
in response to expiration of said first time interval (300; 400), opening the second control switch (S1_0) and closing a first selected high-side switch (S2_1) for a second time interval (302; 402), whereby said current (I_{L}) flows entirely through said first selected high-side switch (S2_1) and is output via a respective first drive output node (13_1); and
in response to expiration of said second time interval (302; 402), opening said first selected high-side switch (S2_1).

13. A method of operating a laser lighting module (11) according to claim 10, the method comprising:
initially opening the first control switch (S1) and the second control switch (S1_0) to charge said capacitor (Cr) via said charging circuitry (16), and
operating the laser-driving device (101) according to the method of claim 12.

## Patentansprüche

1. Laserantriebsvorrichtung (101), umfassend eine Treiberschaltung (100), die mit einer Vielzahl von Laserdioden (LD_j) gekoppelt werden kann, wobei die Treiberschaltung (100) Folgendes umfasst:
einen Halbleiterkörper (504) mit einer ersten Oberfläche (504a);
einen ersten Steuerschalter (S1), der einen Ablaufanschluss (DS1) aufweist, der elektrisch mit einer Ablaufmetallisierung (530) gekoppelt ist, und einen Quellanschluss (SS1) aufweist, der elektrisch mit einer ersten Quellmetallisierung (532) gekoppelt ist, wobei die Ablaufmetallisierung (530) so eingerichtet ist, dass sie elektrisch mit einer Stromversorgungsleitung (12) gekoppelt ist, und die erste Quellmetallisierung (532) so eingerichtet ist, dass sie mit Kathodenanschlüssen der Laserdioden (LD_j) und mit einem Referenzknoten (GND) gekoppelt ist;
eine Vielzahl von High-Side-Schaltern (S2_j), wobei jeder High-Side-Schalter einen jeweiligen Ablaufanschluss (DS2_j) aufweist, der elektrisch mit der Ablaufmetallisierung (530) gekoppelt ist, und einen jeweiligen Quellanschluss (SS2_j) aufweist, der elektrisch mit einer jeweiligen Drittquellen-Metallisierung (534_j) gekoppelt ist, wobei jede Drittquellen-Metallisierung (534_j) mit einem jeweiligen Antriebsausgangsknoten (13_j) zum Antreiben eines Anodenanschlusses (LDa_j) einer jeweiligen Laserdiode (LD_j) der Vielzahl von Laserdioden gekoppelt ist;
**dadurch gekennzeichnet, dass**:
die Treiberschaltung (100) ferner einen zweiten Steuerschalter (S1_0) umfasst, der einen Ablaufanschluss (DS1_0) aufweist, der elektrisch mit der Ablaufmetallisierung (530) gekoppelt ist, und einen Quellanschluss (SS1_0), der elektrisch mit einer zweiten Quellmetallisierung (533) gekoppelt ist, wobei die zweite Quellmetallisierung (533) so eingerichtet ist, dass sie mit den Kathodenanschlüssen der Laserdioden (LD _j) und mit dem Referenzknoten (GND) gekoppelt ist;
wobei die Ablaufmetallisierung (530), die erste 35 Quellmetallisierung (532), die zweite Quellmetallisierung (533) und die dritten Quellmetallisierungen (534_j) der ersten Oberfläche (504a) des Halbleiterkörpers (504) zugewandt sind, der auch so eingerichtet ist, dass sie den Laserdioden (LD_j) zugewandt ist; und
wobei die zweite Quellmetallisierung (533) und die dritten Quellmetallisierungen (534_j) in einer Ausrichtungsrichtung (540) zueinander ausgerichtet sind und orthogonal zur Ausrichtungsrichtung (540) den jeweiligen Quellanschlüssen des zweiten Steuerschalters (S1_0) und der High-Side-Schalter (S2_j) überlagert sind; die Laserantriebsvorrichtung (101) ferner umfassend eine Steuerschaltung (18) zum Antreiben des ersten Steuerschalters (S1), des zweiten Steuerschalters (S1_0) und der High-Side-Schalter (S2_j), um zyklisch Impulse zum Aktivieren der Laserdioden (LD_j) zu erzeugen, wobei die Steuerschaltung (18) so eingerichtet ist, dass sie:
eine Spannung über einen Kondensator (Cr) eines externen Resonanzkreises (LC), der zwischen der Stromversorgungsleitung (12) und dem Referenzknoten (GND) gekoppelt werden kann, erfasst;
als Reaktion darauf, dass die erfasste Spannung einen ersten Schwellenwert erreicht, den ersten Steuerschalter (S1) und den zweiten Steuerschalter (S1_0) schließt, wodurch der Resonanzkreis (LC) mit einem Strom (I_{L}) schwingen kann, der in einem Induktor (Lr) des Resonanzkreises (LC) fließt und zwischen dem ersten Steuerschalter (S1) und dem zweiten Steuerschalter (S1_0) aufgeteilt ist;
als Reaktion darauf, dass der Strom (I_{L}) in dem Induktor (Lr) des Resonanzkreises (LC) einen zweiten Schwellenwert erreicht, den ersten Steuerschalter (S1) öffnet und den zweiten Steuerschalter (S1_0) für ein erstes Zeitintervall (300; 400) geschlossen halten, wobei der Strom (I_{L}) vollständig durch den zweiten Steuerschalter (S1_0) fließt; als Reaktion auf das Ablaufen des ersten Zeitintervalls (300; 400) den zweiten Steuerschalter (S1_0) öffnet und einen ersten ausgewählten High-Side-Schalter (S2_1) für ein zweites Zeitintervall (302; 402) schließt, wobei der Strom (I_{L}) vollständig durch den ersten ausgewählten High-Side-Schalter (S2_1) fließt und über einen jeweiligen ersten Antriebsausgangsknoten (13_1) ausgegeben wird; und als Reaktion auf das Ablaufen des zweiten Zeitintervalls (302; 402) den ersten ausgewählten High-Side-Schalter (S2_1) öffnet.

2. Laserantriebsvorrichtung (101) nach Anspruch 1, wobei ein leitfähiger Kanal des ersten Steuerschalters (S1) größer ist als ein leitfähiger Kanal des zweiten Steuerschalters (S1_0), wobei ein Einschaltwiderstand des ersten Steuerschalters (S1) kleiner ist als ein Einschaltwiderstand des zweiten Steuerschalters (S1_0).

3. Laserantriebsvorrichtung (101) nach Anspruch 1 oder 2, wobei:
der erste Steuerschalter (S1), der zweite Steuerschalter (S1_0) und die High-Side-Schalter (S2_j) jeweils leitfähige Kanäle aufweisen, die sich in einer Richtung senkrecht zur Ausrichtungsrichtung (540) und parallel zur ersten Oberfläche (540a) erstrecken; und
der Quellanschluss (SS1) des ersten Steuerschalters (S1) sich auf einer gegenüberliegenden Seite des Halbleiterkörpers (504) in Bezug auf die Quellanschlüsse (SS1_0, SS2_j) des zweiten Steuerschalters (S1_0) und der High-Side-Schalter (S2_j) befindet.

4. Laserantriebsvorrichtung (101) nach einem der vorhergehenden Ansprüche, wobei der erste Steuerschalter (S1) einen leitfähigen Kanal aufweist, dessen Breite der Summe der Breiten (W) der leitfähigen Kanäle des zweiten Steuerschalters (S1_0) und der High-Side-Schalter (S2_j) entspricht.

5. Laserantriebsvorrichtung (101) nach einem der vorhergehenden Ansprüche, wobei der erste Steuerschalter (S1) eine Vielzahl von ersten Steuertransistoren (S1m_k) umfasst, die elektrisch parallel geschaltet sind, wobei vorzugsweise die Anzahl der ersten Steuertransistoren (S1m_k) gleich der Anzahl des zweiten Steuerschalters (S1_0) plus der High-Side-Schalter (S2_j) ist.

6. Laserantriebsvorrichtung (101) nach Anspruch 5, wobei jeder der ersten Steuertransistoren (S1m_k) , jeder der High-Side-Schalter (S2_j) und der zweite Steuerschalter (S1_0) jeweils leitfähige Kanäle mit derselben Breite (W) aufweisen.

7. Laserantriebsvorrichtung (101) nach einem der vorhergehenden Ansprüche, wobei der Steuerkreis (18) ferner so eingerichtet ist, dass er:
als Reaktion auf das Ablaufen des zweiten Zeitintervalls (302; 402) einen zweiten ausgewählten High-Side-Schalter (S2_2) schließt, der neben dem ersten ausgewählten High-Side-Schalter (S2_1) für ein drittes Zeitintervall (404) liegt, wobei der Strom (I_{L}) von dem ersten ausgewählten High-Side-Schalter (S2_1) zu dem zweiten ausgewählten High-Side-Schalter (S2_2) geschaltet wird und vollständig durch den zweiten ausgewählten High-Side-Schalter (S2_2) fließt und über einen jeweiligen zweiten Antriebsausgangsknoten (13_2) ausgegeben wird; und
als Reaktion auf das Ablaufen des dritten Zeitintervalls (404) den zweiten ausgewählten High-Side-Schalter (S2_2) öffnet.

8. Laserantriebsvorrichtung (101) nach einem der Ansprüche 1 bis 6, wobei die Steuerschaltung (18) ferner so eingerichtet ist, dass sie:
als Reaktion auf das Ablaufen des zweiten Zeitintervalls (302; 402) den zweiten Steuerschalter (S1_0) für ein drittes Zeitintervall (304) schließt, wobei der Strom (I_{L}) von dem ersten ausgewählten High-Side-Schalter (S2_1) zu dem zweiten Steuerschalter (S1_0) geschaltet wird und vollständig durch den zweiten Steuerschalter (S1_0) fließt; und
als Reaktion auf das Ablaufen des dritten Zeitintervalls (304) den zweiten Steuerschalter (S1_0) öffnen und einen zweiten ausgewählten High-Side-Schalter (S2_j) für ein viertes Zeitintervall (306) schließen, wobei der Strom (I_{L}) vollständig durch den zweiten ausgewählten High-Side-Schalter (S2_j) fließt und über einen jeweiligen zweiten Antriebsausgangsknoten (13_j) ausgegeben wird; und
als Reaktion auf das Ablaufen des vierten Zeitintervalls (306) den zweiten ausgewählten High-Side-Schalter (S2_j) öffnet.

9. Laserantriebsvorrichtung (101) nach einem der vorhergehenden Ansprüche, wobei der Steuerkreis (18) eine Vielzahl von Low-Side-Schaltern (S3_j) umfasst, die zum Koppeln mit den jeweiligen High-Side-Schaltern (S2_j) eingerichtet sind, wobei jeder Low-Side-Schalter (S3_j) so eingerichtet ist, dass er zwischen einem der jeweiligen Antriebsausgangsknoten (13_j) und dem Referenzknoten (GND) gekoppelt ist, und wobei der Steuerkreis (18) ferner so eingerichtet ist, dass er jeden der Low-Side-Schalter (S3_j) schließt wenn der jeweilige High-Side-Schalter (S2_j) geöffnet ist.

10. Laserbeleuchtungsmodul (11), umfassend:
eine Laserantriebsvorrichtung (101) nach einem der vorhergehenden Ansprüche;
eine Resonanzschaltung (LC) einschließlich eines Induktors (Lr) und eines Kondensators (Cr), die einen Zwischenknoten (14) zwischen ihnen aufweisen, wobei die Resonanzschaltung (LC) zwischen der Stromversorgungsleitung (12) und dem Referenzknoten (GND) gekoppelt ist;
eine Ladeschaltung (16), die zwischen einem Versorgungsknoten (VCC) und dem Zwischenknoten (14) der Resonanzschaltung (LC) zum Laden des Kondensators (Cr) der Resonanzschaltung (LC) gekoppelt ist; und
eine Vielzahl von Laserdioden (15, LD_j), wobei jede der Laserdioden (LD_j) einen Anodenanschluss (LDa_j) aufweist, der elektrisch mit einem der jeweiligen Antriebsausgangsknoten (13_j) gekoppelt ist, und einen Kathodenanschluss, der elektrisch mit dem Referenzknoten (GND) gekoppelt ist.

11. LIDAR-Vorrichtung (1), umfassend:
einen Laserlichtstrahlpfad (EP), der ein LIDAR-Spiegelmodul (1002) und ein Laserbeleuchtungsmodul (11) nach Anspruch 10 umfasst;
einen Laserlichtempfängerpfad (RP), der ein Photodiodenmodul (1004) und eine mit dem Photodiodenmodul (1004) gekoppelte Empfängerschaltung (1005) umfasst; und eine Steuerungsschaltung (1006), die so eingerichtet ist, dass sie:
Fahrsignalen (TPS, DI) für das LIDAR-Spiegelmodul (1002) und das Laserbeleuchtungsmodul (11) aussendet; und
Rohdaten (RD) von der Empfängerschaltung (1005) empfängt, die mit dem Photodiodenmodul (1004) gekoppelt ist.

12. Verfahren zum Betreiben einer Laserantriebsvorrichtung (101) nach einem der Ansprüche 1 bis 9, wobei das Verfahren Folgendes umfasst:
Erfassen einer Spannung über einen Kondensator (Cr) eines externen Resonanzkreises (LC), der zwischen der Stromversorgungsleitung (12) und dem Referenzknoten (GND) gekoppelt ist;
als Reaktion auf das Erreichen eines ersten Schwellenwerts, Schließen des ersten Steuerschalters (S1) und des zweiten Steuerschalters (S1_0), wodurch der Resonanzkreis (LC) mit einem Strom (I_{L}) schwingen kann, der in einem Induktor (Lr) des Resonanzkreises (LC) fließt und zwischen dem ersten Steuerschalter (S1) und dem zweiten Steuerschalter (S1_0) aufgeteilt ist;
als Reaktion darauf, dass der Strom (I_{L}) in dem Induktor (Lr) des Resonanzkreises (LC) einen zweiten Schwellenwert erreicht, den ersten Steuerschalter (S1) öffnet und den zweiten Steuerschalter (S1_0) für ein erstes Zeitintervall (300; 400) geschlossen hält, wobei der Strom (I_{L}) vollständig durch den zweiten Steuerschalter (S1_0) fließt; als Reaktion auf das Ablaufen des ersten Zeitintervalls (300; 400), den zweiten Steuerschalters (S1_0) öffnen und einen ersten ausgewählten High-Side-Schalter (S2_1) für ein zweites Zeitintervall (302; 402) schließen, wobei der Strom (I_{L}) vollständig durch den ersten ausgewählten High-Side-Schalter (S2_1) fließt und über einen jeweiligen ersten Antriebsausgangsknoten (13_1) ausgegeben wird; und
als Reaktion auf das Ablaufen des zweiten Zeitintervalls (302; 402), Öffnen des ersten ausgewählten High-Side-Schalters (S2_1).

13. Verfahren zum Betreiben eines Laserbeleuchtungsmoduls (11) nach Anspruch 10, wobei das Verfahren Folgendes umfasst:
zunächst das Öffnen des ersten Steuerschalters (S1) und des zweiten Steuerschalters (S1_0), um den Kondensator (Cr) über die Ladeschaltung (16) zu laden, und
Betreiben der Laserantriebsvorrichtung (101) nach dem Verfahren nach Anspruch 12.

## Revendications

1. Dispositif d'attaque laser (101), comprenant un circuit d'attaque (100) pouvant être couplé à une pluralité de diodes laser (LD_j), le circuit d'attaque (100) comprenant :
un corps semi-conducteur (504) présentant une première surface (504a) ;
un premier interrupteur de commande (S1) ayant une borne de drain (DS1) couplée électriquement à une métallisation de drain (530) et ayant une borne de source (SS1) couplée électriquement à une première métallisation de source (532), la métallisation de drain (530) étant configurée pour être couplée électriquement à une ligne d'alimentation électrique (12) et la première métallisation de source (532) étant configurée pour être couplée à des bornes de cathode desdites diodes laser (LD_j) et à un nœud de référence (GND) ;
une pluralité d'interrupteurs côté haut (S2_j), chaque interrupteur côté haut ayant une borne de drain respective (DS2_j) couplée électriquement à ladite métallisation de drain (530) et ayant une borne de source respective (SS2_j) couplée électriquement à une troisième métallisation de source (534_j), chaque troisième métallisation de source (534_j) étant couplée à un nœud de sortie d'attaque respectif (13_j) destiné à attaquer une borne d'anode (LDa_j) d'une diode laser respective (LD_j) de la pluralité de diodes laser ;
**caractérisé en ce que** :
le circuit d'attaque (100) comprend en outre un deuxième interrupteur de commande (S1_0) ayant une borne de drain (DS1_0) couplée électriquement à ladite métallisation de drain (530) et ayant une borne de source (SS1_0) couplée électriquement à une deuxième métallisation de source (533), la deuxième métallisation de source (533) étant configurée pour être couplée auxdites bornes de cathode desdites diodes laser (LD_j) et audit nœud de référence (GND) ;
dans lequel la métallisation de drain (530), la première métallisation de source (532), la deuxième métallisation de source (533) et les troisièmes métallisations de source (534_j) font face à la première surface (504a) du corps semi-conducteur (504), qui est également configurée pour faire face aux diodes laser (LD_j) ; et
dans lequel la deuxième métallisation de source (533) et les troisièmes métallisations de source (534_j) sont alignées les unes avec les autres dans une direction d'alignement (540) et sont superposées, orthogonalement à la direction d'alignement (540), aux bornes de source respectives du deuxième interrupteur de commande (S1_0) et des interrupteurs côté haut (S2_j) ;
le dispositif d'attaque laser (101) comprenant en outre un circuit de commande (18) destiné à piloter le premier interrupteur de commande (S1), le deuxième interrupteur de commande (S1_0) et les interrupteurs côté haut (S2_j) pour générer cycliquement des impulsions destinées à activer lesdites diodes laser (LD_j), le circuit de commande (18) étant configuré pour :
détecter une tension aux bornes d'un condensateur (Cr) d'un circuit résonant externe (LC) pouvant être couplé entre la ligne d'alimentation électrique (12) et le nœud de référence (GND) ;
en réponse au fait que ladite tension détectée atteint une première valeur seuil, fermer le premier interrupteur de commande (S1) et le deuxième interrupteur de commande (S1_0), permettant ainsi au circuit résonant (LC) d'osciller avec un courant (I_{L}) qui circule dans une inductance (Lr) du circuit résonant (LC) et est divisé entre le premier interrupteur de commande (S1) et le deuxième interrupteur de commande (S1_0) ;
en réponse au fait que ledit courant (I_{L}) circulant dans l'inductance (Lr) du circuit résonant (LC) atteint une deuxième valeur seuil, ouvrir le premier interrupteur de commande (S1) et maintenir fermé le deuxième interrupteur de commande (S1_0) pendant un premier intervalle de temps (300 ; 400), en conséquence de quoi ledit courant (I_{L}) circule entièrement à travers ledit deuxième interrupteur de commande (S1_0) ;
en réponse à l'expiration dudit premier intervalle de temps (300 ; 400), ouvrir le deuxième interrupteur de commande (S1_0) et fermer un premier interrupteur côté haut sélectionné (S2_1) pendant un deuxième intervalle de temps (302 ; 402), en conséquence de quoi ledit courant (I_{L}) circule entièrement à travers ledit premier interrupteur côté haut sélectionné (S2_1) et est délivré par l'intermédiaire d'un premier nœud de sortie d'attaque respectif (13_1) ; et
en réponse à l'expiration dudit deuxième intervalle de temps (302 ; 402), ouvrir ledit premier interrupteur côté haut sélectionné (S2_1).

2. Dispositif d'attaque laser (101) selon la revendication 1, dans lequel un canal conducteur dudit premier interrupteur de commande (S1) est plus gros qu'un canal conducteur dudit deuxième interrupteur de commande (S1_0), en conséquence de quoi une résistance à l'état passant dudit premier interrupteur de commande (S1) est plus petite qu'une résistance à l'état passant dudit deuxième interrupteur de commande (S1_0).

3. Dispositif d'attaque laser (101) selon la revendication 1 ou la revendication 2, dans lequel :
ledit premier interrupteur de commande (S1), ledit deuxième interrupteur de commande (S1_0) et lesdits interrupteurs côté haut (S2_j) ont des canaux conducteurs respectifs qui s'étendent dans une direction perpendiculaire à ladite direction d'alignement (540) et parallèle à ladite première surface (540a) ; et
ladite borne de source (SS1) dudit premier interrupteur de commande (S1) est située d'un côté opposé dudit corps semi-conducteur (504) par rapport auxdites bornes de source (SS1_0, SS2_j) dudit deuxième interrupteur de commande (S1_0) et desdits interrupteurs côté haut (S2_j).

4. Dispositif d'attaque laser (101) selon n'importe laquelle des revendications précédentes, dans lequel ledit premier interrupteur de commande (S1) a un canal conducteur présentant une largeur égale à la somme des largeurs (W) des canaux conducteurs dudit deuxième interrupteur de commande (S1_0) et desdits interrupteurs côté haut (S2_j).

5. Dispositif d'attaque laser (101) selon n'importe laquelle des revendications précédentes, dans lequel ledit premier interrupteur de commande (S1) comprend une pluralité de premiers transistors de commande (S1m_k) connectés électriquement en parallèle, le nombre desdits premiers transistors de commande (S1m_k) étant de préférence égal au total dudit deuxième interrupteur de commande (S1_0) et desdits interrupteurs côté haut (S2_j).

6. Dispositif d'attaque laser (101) selon la revendication 5, dans lequel chacun desdits premiers transistors de commande (S1m_k), chacun desdits interrupteurs côté haut (S2_j) et ledit deuxième interrupteur de commande (S1_0) ont des canaux conducteurs respectifs présentant tous la même largeur (W).

7. Dispositif d'attaque laser (101) selon n'importe laquelle des revendications précédentes, dans lequel ledit circuit de commande (18) est en outre configuré pour :
en réponse à l'expiration dudit deuxième intervalle de temps (302 ; 402), fermer un deuxième interrupteur côté haut sélectionné (S2_2) qui est adjacent audit premier interrupteur côté haut sélectionné (S2_1) pendant un troisième intervalle de temps (404), en conséquence de quoi ledit courant (I_{L}) est commuté dudit premier interrupteur côté haut sélectionné (S2_1) audit deuxième interrupteur côté haut sélectionné (S2_2) et circule entièrement à travers ledit deuxième interrupteur côté haut sélectionné (S2_2) et est délivré par l'intermédiaire d'un deuxième nœud de sortie d'attaque respectif (13_2) ; et
en réponse à l'expiration dudit troisième intervalle de temps (404), ouvrir ledit deuxième interrupteur côté haut sélectionné (S2_2).

8. Dispositif d'attaque laser (101) selon n'importe laquelle des revendications 1 à 6, dans lequel ledit circuit de commande (18) est en outre configuré pour :
en réponse à l'expiration dudit deuxième intervalle de temps (302 ; 402), fermer ledit deuxième interrupteur de commande (S1_0) pendant un troisième intervalle de temps (304), en conséquence de quoi ledit courant (I_{L}) est commuté dudit premier interrupteur côté haut sélectionné (S2_1) audit deuxième interrupteur de commande (S1_0) et circule entièrement à travers ledit deuxième interrupteur de commande (S1_0) ; et
en réponse à l'expiration dudit troisième intervalle de temps (304), ouvrir ledit deuxième interrupteur de commande (S1_0) et fermer un deuxième interrupteur côté haut sélectionné (S2_j) pendant un quatrième intervalle de temps (306), en conséquence de quoi ledit courant (I_{L}) circule entièrement à travers ledit deuxième interrupteur côté haut sélectionné (S2_j) et est délivré par l'intermédiaire d'un deuxième nœud de sortie d'attaque respectif (13_j) ; et
en réponse à l'expiration dudit quatrième intervalle de temps (306), ouvrir ledit deuxième interrupteur côté haut sélectionné (S2_j).

9. Dispositif d'attaque laser (101) selon n'importe laquelle des revendications précédentes, dans lequel ledit circuit de commande (18) comprend une pluralité d'interrupteurs côté bas (S3_j) configurés en vue de leur couplage à des interrupteurs respectifs parmi lesdits interrupteurs côté haut (S2_j), dans lequel chaque interrupteur côté bas (S3_j) est configuré pour être couplé entre l'un respectif desdits nœuds de sortie d'attaque (13_j) et ledit nœud de référence (GND), et dans lequel ledit circuit de commande (18) est en outre configuré pour fermer chacun desdits interrupteurs côté bas (S3_j) lorsque l'interrupteur côté haut respectif (S2_j) est ouvert.

10. Module d'éclairage laser (11), comprenant :
un dispositif d'attaque laser (101) selon n'importe laquelle des revendications précédentes ;
un circuit résonant (LC) incluant une inductance (Lr) et un condensateur (Cr) ayant un nœud intermédiaire (14) entre eux, le circuit résonant (LC) étant couplé entre la ligne d'alimentation électrique (12) et le nœud de référence (GND) ;
une circuiterie de charge (16) couplée entre un nœud d'alimentation (VCC) et le nœud intermédiaire (14) du circuit résonant (LC) en vue de la charge du condensateur (Cr) du circuit résonant (LC) ; et
une pluralité de diodes laser (15, LD_j), chacune desdites diodes laser (LD_j) ayant une borne d'anode (LDa_j) couplée électriquement à l'un respectif desdits nœuds de sortie d'attaque (13_j) et une borne de cathode couplée électriquement audit nœud de référence (GND).

11. Appareil LIDAR (1), comprenant :
un chemin d'émission (EP) de lumière laser comprenant un module miroir de LIDAR (1002) et un module d'éclairage laser (11) selon la revendication 10 ;
un chemin de réception (RP) de lumière laser comprenant un module photodiode (1004) et un circuit de réception (1005) couplé au module photodiode (1004) ; et
un circuit contrôleur (1006) configuré pour :
émettre des signaux d'attaque (TPS, DI) destinés audit module miroir de LIDAR (1002) et audit module d'éclairage laser (11) ; et
recevoir des données brutes (RD) provenant dudit circuit de réception (1005) couplé au module photodiode (1004).

12. Procédé d'exploitation d'un dispositif d'attaque laser (101) selon n'importe laquelle des revendications 1 à 9, le procédé comprenant :
la détection d'une tension aux bornes d'un condensateur (Cr) d'un circuit résonant externe (LC) couplé entre la ligne d'alimentation électrique (12) et le nœud de référence (GND) ;
en réponse au fait que ladite tension détectée atteint une première valeur seuil, la fermeture du premier interrupteur de commande (S1) et du deuxième interrupteur de commande (S1_0), permettant ainsi au circuit résonant (LC) d'osciller avec un courant (I_{L}) qui circule dans une inductance (Lr) du circuit résonant (LC) et est divisé entre le premier interrupteur de commande (S1) et le deuxième interrupteur de commande (S1_0) ;
en réponse au fait que ledit courant (I_{L}) circulant dans l'inductance (Lr) du circuit résonant (LC) atteint une deuxième valeur seuil, l'ouverture du premier interrupteur de commande (S1) et le maintien du deuxième interrupteur de commande (S1_0) fermé pendant un premier intervalle de temps (300 ; 400), en conséquence de quoi ledit courant (I_{L}) circule entièrement à travers ledit deuxième interrupteur de commande (S1_0) ;
en réponse à l'expiration dudit premier intervalle de temps (300 ; 400), l'ouverture du deuxième interrupteur de commande (S1_0) et la fermeture d'un premier interrupteur côté haut sélectionné (S2_1) pendant un deuxième intervalle de temps (302 ; 402), en conséquence de quoi ledit courant (I_{L}) circule entièrement à travers ledit premier interrupteur côté haut sélectionné S2_1) et est délivré par l'intermédiaire d'un premier nœud de sortie d'attaque respectif (13_1) ; et
en réponse à l'expiration dudit deuxième intervalle de temps (302 ; 402), l'ouverture dudit premier interrupteur côté haut sélectionné (S2_1).

13. Procédé d'exploitation d'un module d'éclairage laser (11) selon la revendication 10, le procédé comprenant :
initialement, l'ouverture du premier interrupteur de commande (S1) et du deuxième interrupteur de commande (S1_0) pour charger ledit condensateur (Cr) par l'intermédiaire de ladite circuiterie de charge (16), et
l'exploitation du dispositif d'attaque laser (101) selon le procédé de la revendication 12.
